# EUROPÄISCHE PATENTSCHRIFT

(11) **EP 1 828 432 B1**
(45) Veröffentlichungstag und Bekanntmachung des Hinweises auf die Patenterteilung: **20.08.2008**
(21) Anmeldenummer: 05801419.2
(22) Anmeldetag: 24.10.2005
(51) Int. Cl.: C23C 16/24, C23C 16/12, C23C 16/14, C23C 16/56, C23C 10/08

(54) **VERFAHREN ZUM KORROSIONSSCHUTZ VON BAUTEILEN AUS WARMFESTEM STAHL**
METHOD FOR PROTECTING PARTS MADE OF CREEP-RESISTANT STEEL FROM CORRODING
PROCEDE POUR PROTEGER DES COMPOSANTS EN ACIER RESISTANT AU FLUAGE CONTRE LA CORROSION

(30) Priorität: 27.10.2004 DE 102004053502
(43) Veröffentlichungstag der Anmeldung: 05.09.2007
(73) Patentinhaber: Universität Stuttgart, 70174 Stuttgart (DE)
(72) Erfinder: BERRETH, Karl, 70569 Stuttgart (DE); LYUTOVICH, Abram, 70569 Stuttgart (DE); MAILE, Karl, 70569 Stuttgart (DE)
(74) Vertreter: Gahlert, Stefan
(86) Internationale Anmeldenummer: PCT/EP2005/011399
(87) Internationale Veröffentlichungsnummer: WO 2006/045576

(56) Entgegenhaltungen:
- EP-A- 0 509 907
- WO-A-99/43445
- WO-A-03/093530
- GB-A- 2 107 360
- ROOS E ET AL: "Chemical vapour deposition of PyC-SixCy-SiC-Si3N4 multilayer with graded C...SiC transition" SURFACE & COATINGS TECHNOLOGY ELSEVIER SWITZERLAND, Bd. 180-181, 1. März 2004 (2004-03-01), Seiten 465-469, XP002377082 ISSN: 0257-8972

## Beschreibung

Die Erfindung betrifft ein Verfahren zum Korrosionsschutz von Bauteilen aus warmfestem Stahl, insbesondere zum Korrosionsschutz von Kesselrohren aus einem chromhaltigen Stahl.

Überhitzerrohre in kohlebefeuerten Kesseln von Dampfkraftwerken sind einer wasserseitigen Oxidation ausgesetzt. Die Oxidschicht bewirkt einen schlechteren Wärmeübergang des Mediums Dampf auf das Rohr, so dass die Metalltemperatur ansteigt und das Rohr infolge Kriechens vorzeitig versagen kann. Rohre, die in einem Ethylen-Crack-Ofen eingesetzt werden, müssen von Zeit zu Zeit von dem an der Innenoberfläche aufwachsenden C-Belag gereinigt werden, der, wie zuvor erwähnt, eine Verschlechterung des Wärmeübergangs bewirkt. Der Kohlenstoff aus dem Ethylen diffundiert in den Rohrgrundwerkstoff und verursacht eine Degradation, d.h. setzt die Festigkeit des Werkstoffs herab. Beide Effekte führen zum vorzeitigen Ausfall des Rohrs bzw. zu einem erhöhten Wartungsaufwand und zur Reduktion der Einsatzzeit.

Bislang wurden als Rohrwerkstoff Stähle eingesetzt, die einen höheren Chromgehalt und damit ein besseres Oxidationsverhalten aufwiesen, oder die Dampftemperatur betrug maximal 550 °C, so dass dieser Effekt nicht auftrat. Hohe Wirkungsgrade in modernen Hochleistungskraf twerken sind jedoch nur mit erhöhten Dampftemperaturen bis über 600 °C möglich. Aus diesem Grund ist es notwendig, Stähle mit reduziertem Chromgehalt und den damit verbundenen besseren Zeitstandfestigkeiten - aber auch mit schlechterem Oxidation sverhalten - einzusetzen. Die Möglichkeiten, über eine verbesserte Legierungszusammensetzung die gewünschte Oxidationsbeständigkeit zu erzielen, sind technisch begrenzt, da die die Oxidationsbeständigkeit steigernden Elemente gleichzeitig die unbedingt erforderliche Zeitstandfestigkeit reduzieren können. Die derzeit auf dem Markt erhältlichen Stähle für den Anwendungsbereich 580 °C und mehr als Kesselrohre weisen sämtlich keine ausreichende Beständigkeit gegen wasserseitige Oxidation auf.

Es besteht somit das Bedürfnis nach einem Verfahren, die Korrosionsbeständigkeit derartiger Stähle zu steigern.

Aus der EP 0 509 907 B ist ein Verfahren zum Aufbringen einer Siliziumdiffusions- bzw. einer Überzugsbeschichtung auf der Oberfläche eines Stahls bekannt, bei dem die Stahloberfläche gereinigt, poliert und entgast wird. Anschließend wird dar Stahl mittels eines CVD-Verfahrens bei einer Temperatur zwischen 650 °C und 1000 °C einer Siliziumdiffusionsbehandlung unter Verwendung von Silan (SiH₄) unterzogen. Das Silan kann mit einem Trägergas, wie Argen, Helium und/oder Wasserstoff verdünnt oder unverdünnt verwendet werden. Hierbei wird eine Siliziumkonzentration in der Deckschicht von mehr als 7 Gew.-% bis zu etwa 14,5 Gew.-% erzeugt.

Ein derartiges Verfahren lässt sich wegen der großen benötigten Mengen an Silan industriell nur mit sehr hohem Aufwand einset - zen, da Silan selbstentzündlich ist. Eine hiermit erzeugte Siliziumschicht im Oberflächenbereich mit einer derartig hohen Konzentration führt zur Versprödung und kann im Dauerbetrieb insbesondere bei wechselnder Temperaturbelastung leicht abplatzen. Insbesondere zum Schutz von chromarmen Stählen für Kesselrohre gegenüber wasserseitiger Korrosion ist ein derartiges Verfahren nicht geeignet.

Aus der US 5 089 061 A ist ein Verfahren zum Herstellen von hochsiliziumhaltigem Bandstahl mit einer kontinuierlichen Verfahrensführung bekannt, bei dem der Bandstahl bei Temperaturen zwischen 1023 °C und 1200 °C in einer nicht oxidierenden Gasatmosphäre, die zwischen 5 und 35 Mol-% SiCl₄ enthält, mittels CVD behandelt wird. Anschließend wird das Blech einer Diffusionsbehandlung bei einer höheren Temperatur in einer nicht oxidierenden Atmosphäre unterzogen, um eine Diffusion des Siliziums zu bewirken. Bei der Behandlung entsteht Eisenchlorid, was für einen Korrosionsschutz unerwünscht ist und die Korrosionsanfälligkeit noch erhöht. Zur Behandlung der Innenoberfläche von Rohren ist das bekannte Verfahren nicht geeignet.

Aus K. Maile, K. Berreth, A. Lyutovich: "Modifizierung der Stahloberfläche mittels CVD und chemischer Konversion zum Schutz von Kesselrohren vor wasserseitiger Korrosion" in VGB-Fachtagung "Werkstoffe und Qualitätssicherung", 10. und 11.03. 2004, Zeche Zollern II/IV, Dortmund, ist es bekannt, die Innenoberfläche von Rohren aus dem Werkstoff X10CrMoVNb9-1 mittels einer CVD-Behandlung vor Korrosion zu schützen. Bei der Reaktion von SiCl₄ und H₂ mit der Stahloberfläche diffundiert Silizium bei einer Prozesstemperatur von 1050 °C in den Stahl. Es bildet sich eine mit Si angereicherten oberflächennahe Schicht mit verbessertem Oxidations- bzw. Zunderverhalten. Der Überschuss von Si wird mit NH₃ zu Si₃N₄ umgewandelt. An der Oberflächenschicht soll sich eine ferritische Phase ausbilden und der Gehalt des Siliziums Eisen soll zu etwa 5 % ersetzt werden, während der Chromgehalt nahezu unverändert bleiben soll.

Mit dem beschriebenen Verfahren ist zwar grundsätzlich ein Korrosionsschutz der Innenoberfläche von Kesselrohren ermöglicht, jedoch verbleibt das Problem freigesetzten Chlors, der sich nachteilig auf den Korrosionsschutz auswirken kann. Auch wurde nicht offenbart, wie den der angestrebte Korrosionsschutz im Detail tatsächlich erreicht werden kann.

Der Erfindung liegt somit die Aufgabe zugrunde, ein Verfahren für einen verbesserten Korrosionsschutz von Bauteilen aus warmfestem Stahl, insbesondere zum Korrosionsschutz von Kesselrohren aus einem chromhaltigen Stahl, bereitzustellen, mit dem sich ein sicherer Korrosionsschutz auf einfache und zuverlässige Weise erzielen lässt. Hierbei sollen möglichst die hohen Qualitätsanforderungen erfüllt werden, die insbesondere an warmfeste Stähle gestellt werden, die für Kesselrohre im Kraftwerksbetrieb bei Temperaturen bis zu 600 °C und mehr eingesetzt werden.

Diese Aufgabe wird erfindungsgemäß durch ein Verfahren zum Korrosionsschutz von Bauteilen aus warmfestem Stahl gelöst, insbesondere zum Korrosionsschutz von Kesselrohren aus einem chromhaltigen Stahl, bei dem die zu schützende Oberfläche durch ein Abscheidungsverfahren aus der Gasphase, insbesondere durch ein CVD-Verfahren, mit einem ein Behandlungsgas enthaltenden Gas vorzugsweise unter nicht oxidierender Atmosphäre vorzugsweise bei einer Temperatur zwischen 1000 °C und 1200 °C behandelt wird, wobei die Behandlung mit dem Behandlungsgas in mehreren aufeinander folgenden Behandlungszyklen und mit Diffusionszyklen zwischen den Behandlungszyklen durchgeführt wird, wobei das Behandlungsgas aus der Gruppe ausgewählt ist, die durch Chloride von Elementen der Gruppen IIb, IIIb, IVa und IVb gebildet ist, und wobei das Behandlungsgas vorzugsweise aus der durch SiCl₄, TiCl₄, AlCl₃ und ZnCl₂ gebildeten Gruppe ausgewählt ist.

Die Aufgabe der Erfindung wird auf diese Weise vollkommen g e-löst.

Erfindungsgemäß wird durch die pulsweise Freisetzung des Behandlungsmediums, wie etwa Silizium, aus dem Behandlungsgas in Behandlungszyklen, die von Diffusionszyklen gefolgt sind, erreicht, dass eine kurzzeitige Einwirkung des Behandlungsmediums bei einer Temperatur ermöglicht ist, die ausreichend hoch ist, um eine ausreichende Diffusionsgeschwindigkeit in Stahl zu gewährleisten. Nach jedem Behandlungszyklus werden im folgenden Diffusionszyklus über eine "Chlorentfernung" die Diffusion des Behandlungsmediums und die Rediffusion von Chrom bewirkt. Durch diesen Diffusionszyklus wird ein gleichmäßiger Chromanteil und eine Abgabe des für den Korrosionsschutz nachteiligen chlors erreicht.

Bevorzugt wird als Behandlungsgas SiCl₄ verwendet, was zur Freisetzung von Silizium als Behandlungsmedium führt. Alternativ können jedoch auch TiCl₄, AlCl₃ und/oder ZnCl₂ verwendet werden, was zur Freisetzung von Titan, Aluminium bzw. Zink führt, die in ähnlicher Weise wie Silizium wirken. Daneben ist die Verwendung anderer Chloride von Elementen der Gruppen IIb, IIIb, IVa und IVb möglich.

Mit dem erfindungsgemäßen Verfahren wird gewährleistet, dass die vorteilhafte Schweißbarkeit und Biegefähigkeit des Stahls, wie etwa beim Stahl P91, erhalten bleibt. Auch Schweißnähte und gebogene (d.h. kalt verformte) Bauteile können nach dem erfindungsgemäßen Verfahren behandelt werden.

In vorteilhafter Weiterbildung der Erfindung sind die Diffusionszyklen nach den Behandlungszyklen mindestens so lang wie die Behandlungszyklen, vorzugsweise länger als die Behandlungszyklen.

Hierbei können die Behandlungszyklen beispielsweise etwa 5 bis 120 Sekunden dauern, vorzugsweise etwa 10 bis 30 Sekunden.

Die Diffusionszyklen können hierbei eine Länge haben, die beispielsweise dem 1,0-fachen bis dem 3,0-fachen, vorzugsweise dem 1,5-fachen bis 2,5-fachen, also beispielsweise der doppelten Länge der Behandlungszyklen entsprechen.

Vorzugsweise werden hierbei etwa 5 bis 60 Behandlungszyklen, vorzugsweise 10 bis 50, besonders bevorzugt 20 bis 40, insbesondere etwa 25 bis 35 Behandlungszyklen durchgeführt.

Mit kürzeren Behandlungszyklen bei entsprechend höherer Anzahl von Behandlungszyklen kann eine Übersättigung der Gasphase vermieden werden, die zu Kristallbildung an der Oberfläche führen könnte. Abgeschiedene Kristalle des Behandlungsmediums, wie etwa Siliziumkristalle, Titankristalle oder Aluminiumkristalle an der Oberfläche sind zwar nicht nachteilig per se, wirken jedoch als Diffusionsbarriere.

Als Trägergas für das das Behandlungsgas, wie etwa SiCl₄, enthaltende Gas wird vorzugsweise ein reduzierendes Gas, vorzugsweise ein Wasserstoff enthaltendes Gas oder reiner Wasserstoff verwendet.

Die Behandlung kann auch bei Niederdruck unterhalb von 1 bar durchgeführt werden.

So kann der Verbrauch von Wasserstoff reduziert werden. Das verwendete Behandlungsgas wird allerdings hierbei durch eine Vakuumpumpe gezogen, weshalb in diesem Fall eine Reinigung bzw. Filterung erforderlich ist.

Die Behandlung kann ferner mit einer Aufkohlung kombiniert werden. Eine vollständige oder örtliche Aufkohlung ist möglich. Hierzu kann als Kohlenstoffträger etwa Methan, Acetylen oder ein anderer geeigneter Kohlenstoffträger verwendet werden (auch die Verwendung fester Kohlenstoffträger ist möglich).

Das erfindungsgemäße Verfahren ist insbesondere zum Korrosionsschutz des Stahls XlOCrMoVNb9-1 geeignet, da dieser weniger als 12 Gew.-% Chrom enthält, nämlich zwischen 7 und 11 Gew.-% bzw. nach der Spezifikation 9 Gew.-% Chrom.

Derartig niedrige Chromanteile sind nicht ausreichend, um ohne zusätzliche spezielle Korrosionsschutzbehandlung eine wasserseitige Korrosion bei Betriebstemperaturen von 560 °C und mehr zu verhindern.

Das erfindungsgemäße Verfahren ist ferner für Stähle vorteilhaft verwendbar, die, wie der zuvor erwähnte Stahl, Molybdänanteile zwischen 0,5 und 3 Gew.-%, vorzugsweise zwischen 0,8 und 1,2 Gew.-% Molybdän aufweisen, sowie 0,05 bis 0,8 Gew.-% Vanadium, vorzugsweise 0,1 bis 0,3 Gew.-% Vanadium, sowie 0,01 bis 0,3 Gew.-% Niob, vorzugsweise 0,05 bis 0,15 Gew.-% Ni ob, wobei der Kohlenstoffanteil beispielsweise 0,05 bis 0,2 Gew-%, beispielsweise 0,07 bis 0,15 Gew.-% betragen kann.

Es versteht sich jedoch, dass das erfindungsgemäße Verfahren nicht lediglich auf den Korrosionsschutz des zuvor erwähnten Stahls X10CrMoVNb9-1 beschränkt ist, sondern dass das erfindungsgemäße Verfahren zum Korrosionsschutz von beliebigen Stählen verwendet werden kann, die einen Chromanteil aufweisen.

Insbesondere ist das erfindungsgemäße Verfahren auch zum Korrosionsschutz von Stählen vorteilhaft einsetzbar, die deutlich höhere Chromanteile oberhalb von 12 Gew.-% aufweisen.

Verwendet man das erfindungsgemäße Verfahren jedoch zum Korrosionsschutz des zuvor erwähnten Stahls X10CrMoVNb9-1 (1.4903, P91), so ist es vorteilhaft, die Behandlung bei einer durchschnittlichen Temperatur zwischen 1040 °C und 1080 °C durchzuführen.

Besonders bevorzugt ist es hierbei, den Stahl im Bereich der zu behandelnden Oberfläche kurzzeitig auf eine erhöhte Temperatur oberhalb der durchschnittlichen Behandlungstemperatur zu erwärmen.

Auf diese Weise wird eine Freisetzung des Behandlungsmediums bei einer ausreichend hohen Temperatur gewährleistet, die eine ausreichende Diffusionsgeschwindigkeit in Stahl ermöglicht. Damit sind andere Anlagenteile vor dem Angriff von Chlor geschützt.

Eine kurzzeitige lokale Temperaturerhöhung im Bereich der zu behandelnden Oberfläche kann beispielsweise durch eine Induktionsheizung unter Ausnutzung des Skin-Effektes, durch eine Strahlungsheizung, eine Laserunterstützung, durch erhitztes Gas, durch Mikrowellen, durch einen erhitzten Draht oder dg1. erreicht werden.

Unabhängig davon, welches Verfahren zur kurzzeitigen Temperaturerhöhung im Bereich der Behandlungsoberfläche genutzt wird, wird auf diese Weise eine verstärkte Diffusion erreicht, ohne dass eine zu hohe Temperatur über längere Zeit erhalten wird, was sich nachteilig auf die mechanischen Eigenschaften des Stahls, insbesondere auf die Standfestigkeit und Langzeitbeständigkeit bei hoher Temperaturbelastung, auswirken würde. Auf diese Weise kann die Behandlung bei der vorgeschriebenen durchschnittlichen Normtemperatur von 1040 °C bis 1080 °C durchgeführt werden, wie sie für die Freigabe des Stahls X10CrMoVNb9-1 für die Verwendung in Kesselrohren in Kraftwerken vorgeschrieben ist. Die kurzzeitige lokale Temperaturerhöhung liegt innerhalb des von der Norm vorgegebenen Bereiches von 1040 °C bis 1080 °C für die Glühbehandlung zum Härten des Stahls, während hierdurch gleichzeitig eine verstärkte Siliziumdiffusion gewährleistet wird. Damit kann der Behandlungszyklus vorteilhaft mit der für die zum Härten ohnehin notwendige Glühbehandlung gekoppelt werden, was zeit- und kostensparend ist.

Anstelle oder zusätzlich zur kurzzeitigen lokalen Temperaturerhöhung im Bereich der Behandlung mit dem Behandlungsmedium, wie etwa Silizium, kann etwa eine Plasmaunterstützung verwendet werden, um eine verstärkte Siliziumdiffusion bei einer niedrigeren Temperatur zu erreichen. So könnte z.B. ein Plasma-Enhanced-Coating (PEC) verwendet werden, ein Wasserstoffplasma oder ein Niederenergieplasma.

Auch der Einsatz anderer grundsätzlich bekannter Verfahren zur Verstärkung der Siliziumdiffusion ist denkbar.

In vorteilhafter Weiterbildung der Erfindung ist die Behandlung von einer zweiten Glühbehandlung bei einer niedrigeren Anlasstemperatur gefolgt. Diese zweite Glühbehandlung kann mit einem Vergütungsschritt gekoppelt sein.

Hierbei kann die zweite Glühbehandlung etwa bei einer Temperatur zwischen 650 °C und 850 °C, vorzugsweise zwischen 730 °C und 780 °C erfolgen.

Vorteilhaft wird die zweite Glühbehandlung unter einer Atmosphäre durchgeführt, wie etwa Stickstoff, die eine Freisetzung von Wasserstoff fördert.

Diese Maßnahmen haben den Vorteil, dass so eine Entfernung des Wasserstoffs aus dem Stahl bewirkt wird, so dass der Wasserstoffgehalt nach der Behandlung mit SiCl₄ unter Wasserstoffatmosphäre nicht größer ist als zuvor. So wird der gefürchteten "Wasserstoffversprödung" mit sprödem Bruchverhalten entgegengewirkt.

Auch der zweite Glühschritt kann vorteilhaft mit dem Anlassschritt gekoppelt sein, der zwischen 730 °C und 780 °C etwa bei dem Stahl P91 durchgeführt wird.

In vorteilhafter Weiterbildung der Erfindung wird vor der Behandlung ein Reinigungsschritt durchgeführt, vorzugsweise mit einem reduzierenden Gas, wie etwa mit Wasserstoff.

Die so bei nahtlosen Rohren vorhandene natürliche Zunderschicht kann so entfernt oder gereinigt werden, bis diese für Silizium so porös ist, dass Silizium in den Grundwerkstoff diffundieren kann und die Zunderschicht quasi versiegeln kann, was teilweise auch unter Bildung von SiO₂ erfolgt.

In weiter bevorzugter Ausgestaltung der Erfindung wird nach Beendigung der Behandlungszyklen oder Diffusionszyklen ein stickstoffhaltiges Gas, insbesondere ein Ammoniak enthaltendes Gas, zugeführt.

Hierdurch kann erreicht werden, dass noch auf der Oberfläche vorhandenes Silizium zu Si₃N₄ umgesetzt wird. Durch eine solche, wenn auch sehr dünne, Siliziumnitridschicht auf der Oberfläche kann die Korrosionsbeständigkeit weiter verbessert werden.

Ferner kann gemäß einer weiteren Ausgestaltung der Erfindung nach Beendigung der Behandlungszyklen oder der Diffusionszyklen oder der Zufuhr von stickstoffhaltigem Gas eine Evakuierung durchgeführt werden, was vorzugsweise noch bei erhöhter Temperatur durchgeführt wird.

Auch hierdurch wird die Freisetzung von Wasserstoff gefördert, der bei den vorherigen Behandlungsschritten in den Werkstoff diffundiert ist.

Wie zuvor bereits erwähnt, ist das erfindungsgemäße Verfahren insbesondere zur Behandlung der Innenoberfläche von Rohren geeignet. Jedoch versteht es sich, dass auch die Außenoberfläche von Rohren behandelt werden kann und dass natürlich auch anders geformte Bauteile und Flachstähle behandelt werden können.

Ferner kann das erfindungsgemäße Verfahren vorteilhaft auch zur Behandlung von Innenrohren für faserumwickelte Rohre verwendet werden. Dabei wird die Zeitstandfestigkeit anteilig durch die Faserverstärkung bewirkt und die Dichtheit sowie die Sicherheit durch das erfindungsgemäß behandelte Stahlinnenrohr gewährleistet.

So lassen sich höhere Prozesstemperaturen in Kraftwerken erreichen (sog. 700 °C-Kraftwerke).

Es versteht sich, dass die vorstehend genannten und die nachstehend noch zu erläuternden Merkmale der Erfindung nicht nur in der jeweils angegebenen Kombination, sondern auch in anderen Kombinationen oder in Alleinstellung verwendbar sind, ohne dem Rahmen der Erfindung zu verlassen.

Weitere Merkmale und Vorteile der Erfindung ergeben sich aus der nachfolgenden Beschreibung bevorzugter Ausführungsbeispiele unter Bezugnahme auf die Zeichnung. Es zeigen:
- Fig. 1: ein Schema der Wärmebehandlung des Stahls P91, die mit der erfindungsgemäßen Korrosionsschutzbehandlung gekoppelt werden kann;
- Fig. 2: eine schematische Darstellung der verwendeten Heiz-und Gasbehandlungszyklen bei dem erfindungsgemäßen Verfahren;
- Fig. 3: das Phasendiagramm Fe-Si mit dem bevorzugten Siliziumanteil zur Ausbildung einer ferritischen Phase im Oberflächenbereich des Stahls;
- Fig. 4: ein Konzentrationsprofil für Silizium und Chrom über den oberflächennahen Bereich eines nach dem erfindungsgemäßen Verfahren behandelten Stahls P91;
- Fig. 5: einen Korrosionstest mit 10 % Wasserdampf zum Vergleich an nicht behandeltem Stahl P91 und an erfindungsgemäß behandeltem Stahl P91; und
- Fig. 6: eine schematische Darstellung einer Vorrichtung zur Durchführung des erfindungsgemäßen Verfahrens an der Innenoberfläche von langen Rohren in industriellem Maßstab.

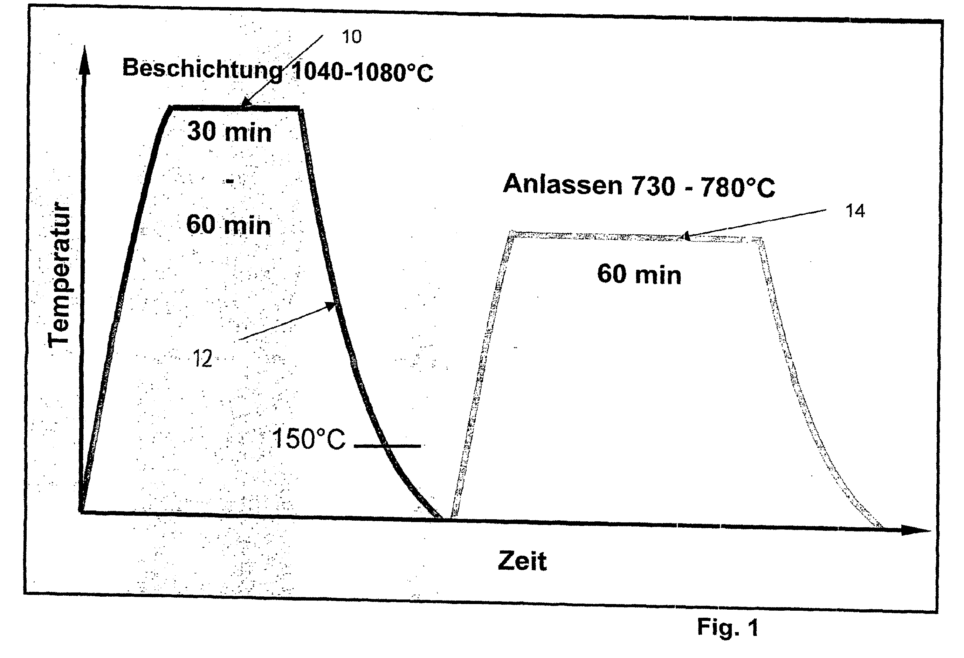

Fig. 1 zeigt die laut Norm vorgeschriebene Wärmebehandlung für den Stahl X10CrMoVNb9-1 (1.4903; P91; T91), sofern dieser für Kesselrohre in Kraftwerken verwendet werden soll.

Hiernach wird der Stahl über eine Dauer von 30 bis 60 Minuten bei 1040 °C bis 1080 °C geglüht und anschließend unter Luftkühlung abgeschreckt. Danach erfolgt ein Vergütungsschritt durch ein Anlassen auf eine Temperatur zwischen 730 °C und 780 °C über eine Dauer von 60 Minuten.

Das erfindungsgemäße Verfahren, etwa zur Innenbeschichtung von Rohren aus dem Stahl P91, lässt sich nun mit diesen vorgeschriebenen Behandlungsschritten, nämlich der ersten Glühbehandlung 10 zwischen 1040 °C und 1080 °C sowie der zweiten Glühbehandlung 14 zwischen 730 °C und 780 °C, koppeln.

Die hervorragenden Eigenschaften des Grundwerkstoffes (hohe Zeitstandfestigkeit) werden somit nicht beeinträchtigt.

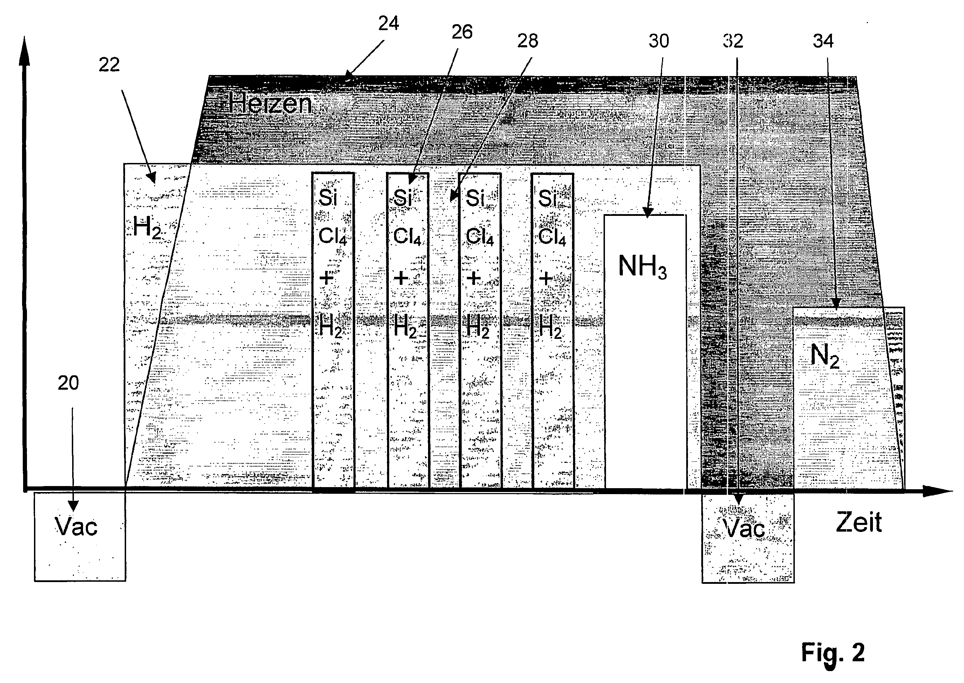

Der grundsätzliche Ablauf des Verfahrens ist in Fig. 2 schematisch dargestellt.

Hiernach erfolgt zunächst ein Evakuierungsschritt 20. Daran schließt sich ein Reinigungsschritt 22 an, während dessen Wasserstoff im Durchfluss eingelassen wird, um eine Reinigung der zu behandelnden Oberfläche zu erzielen. Hierbei kann außerdem schon mit dem Aufheizen auf eine Behandlungstemperatur zwischen 1040 °C und 1080 °C begonnen werden (Heizschritt 24). Durch die Reinigung mit Wasserstoff wird die natürliche Zunderschicht des Stahls aufgebrochen oder abgelöst. Dies dient zur Vorbereitung für die nachfolgende CVD-Behandlung mit SiCl₄. Schließlich werden nacheinander eine Reihe von CVD-Behandlungszyklen 26 mit SiCl₄ unter Wasserstoffatmosphäre bei der Behandlungstemperatur durchgeführt, die im vorliegenden Fall zwischen 1040 °C und 1080 °C liegt. Nach jedem Behandlungszyklus, der eine Dauer von beispielsweise 30 bis 120 Sekunden, vorzugsweise von etwa einer Minute, haben kann, erfolgt ein Diffusionszyklus 28, dessen Dauer vorzugsweise mindestens der Dauer des vorhergehenden Behandlungszyklus entspricht. Der Diffusionszyklus nach jedem Behandlungszyklus ist für eine Chlorentfernung, die Diffusion von Silizium und die Rediffusion von Chrom notwendig. Hierdurch wird das für einen Korrosionsschutz an sich nachteilige Chlor wieder freigesetzt, während dem während des vorhergehenden Behandlungszyklus durch den CVD-Prozess freigesetzten Silizium ausreichend Zeit zur Diffusion in oberflächennahe Schichten des Stahls zur Verfügung steht.

So wird nacheinander bei der Behandlungstemperatur, die für den Stahl P91 vorzugsweise zwischen 1040 °C und 1080 °C liegt, eine Folge von 5 bis 25 Behandlungszyklen, vorzugsweise von etwa 10 bis 12 Behandlungszyklen, durchgeführt, die jeweils von einem Diffusionszyklus gefolgt werden, der mindestens gleich lang ist, vorzugsweise etwas länger, beispielsweise 90 Sekunden beträgt bei einem vorhergehenden Behandlungszyklus von 60 Sekunden.

Nach Beendigung der CVD-Behandlung bzw. nach dem letzten Diffusionszyklus kann gegebenenfalls zusätzlich noch eine kurzzeitige Behandlung mit Ammoniak durchgeführt werden, um freies Silizium an der Oberfläche in Siliziumnitrid umzusetzen. Dieser Behandlungsschritt 30 mit NH₃ wird jedoch so kurz gehalten, dass sich nur eine sehr dünne Oberflächenschicht von Siliziumnitrid bilden kann, die zusätzlich korrosionsschützend wirkt. Anschließend wird noch bei der Behandlungstemperatur (im vorliegenden Fall 1040 °C bis 1080 °C) ein Evakuierungsschritt 32 durchgeführt.

Dies unterstützt eine Wasserstofffreisetzung. Anschließend erfolgt eine Abkühlung auf Raumtemperatur, wozu ein Abschalten der Heizung ausreicht. Dies dient gleichzeitig der Härtung des Stahls. Hieran schließt sich dann eine zweite Glühbehandlung 34 an, die, wie in Fig. 1 gezeigt, vorzugsweise bei 730 °C bis 780 °C über eine Dauer von 60 Minuten durchgeführt wird. Dies erfolgt unter einer Atmosphäre, die eine Wasserstofffreisetzung fördert, beispielsweise unter einer Stickstoff-Atmosphäre. Während dieses Anlassschrittes, der gleichzeitig der Vergütung des Stahls dient, wird der zuvor aufgenommene Wasserstoff wieder vollständig aus dem Stahl entfernt, so dass am Ende des gesamten Verfahrens der Stahl nicht mehr Wasserstoff als zu Beginn der Behandlung enthält, so dass eine Wasserstoffversprödung sicher vermieden wird.

Es versteht sich, dass die Darstellung in Fig. 2 lediglich rein schematischer Natur ist, um das Grundprinzip des erfindungsgemäßen Verfahrens zu erläutern.

Vorzugsweise wird die Konzentration des zugeführten SiCl₄ in der Wasserstoffatmosphäre und die Temperatur der Behandlung nebst der Anzahl und Dauer der Behandlungs- und Diffusionszyklen derart gesteuert, dass der Stahl in seinem oberflächennahen Bereich eine Siliziumkonzentration von etwa 4 bis 5 Gew.-% aufnimmt.

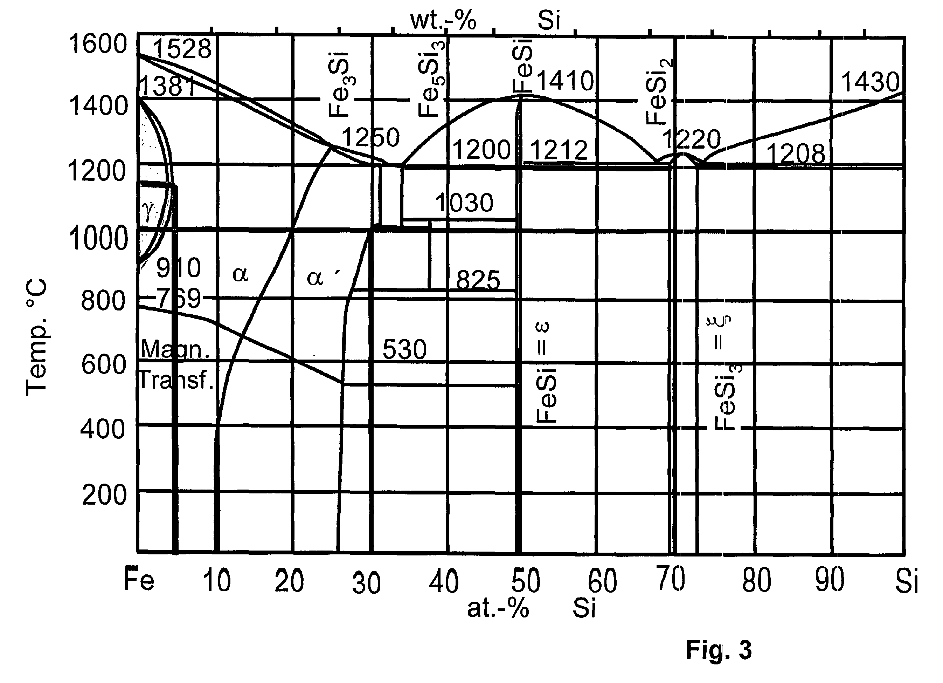

Mit diesem Anteil erfolgt, wie aus dem Zustandsdiagramm gemäß Fig. 3 zu ersehen ist, eine Phasenumwandlung in die ferritische Gammaphase. Bei der anschließenden Abkühlung des Stahls wandelt sich lediglich der Restanteil in Martensit um. Auch bei der späteren Temperaturbehandlung (zweiter Glühschritt) bleibt die weiche, ferritische Schicht erhalten, die als Korrosionsschutz dient. Untersuchungen haben gezeigt, dass die ferritische Grenzschicht, in der das Silizium gelöst ist, bis an die martensitische Grundstruktur des Stahls heranreicht. Dies ist besonders vorteilhaft, da das Silizium lediglich in der oberflächennahen, ferritischen Grenzschicht enthalten ist und nicht in die martensitische Stahl-Grundstruktur einwandert, da dies zu einer Versprödung des Stahls führen würde und beim Schweißen Rissbildungen auftreten würden.

Wird der Prozess, wie zuvor erläutert, derart gesteuert, dass sich ein Siliziumgehalt zwischen etwa 4 und 5 Gew.-% in der oberflächennahen Schicht einstellt, so führt dies zu einem optimalen Korrosionsschutz durch die Ausbildung einer weichen ferritischen siliziumhaltigen Schicht.

Gleichwohl hat es sich gezeigt, dass auch mit geringeren Siliziumkonzentrationen etwa in der Größenordnung von 1 bis 3 % schon ein wirksamer Korrosionsschutz erzielt werden kann.

Eine besonders vorteilhafte Verfahrensführung ergibt sich, wenn die Temperatur aufgrund der CVD-Behandlungszyklen mit SiCl₄ kurzzeitig lokal über die durchschnittliche Temperatur angehoben wird. Dies hat den besonderen Vorteil, dass die Zersetzung von SiCl₄ und damit die Freisetzung von Silizium bei einer ausreichend hohen Temperatur erfolgt, um eine hohe Diffusionsgeschwindigkeit von SiLizium im Stahl zu ermöglichen. Dabei diffundiert das Silizium ausreichend schnell in die oberflächennahe Randzone des Stahls, während der freigesetzte Chlor im Diffusionsschritt abgegeben wird und ein Angriff von Chlor vermieden wird.

Eine kurzzeitige lokale Temperaturanhebung über die von der Norm vorgegebene maximale Durchschnittstemperatur von 1080 °C für den Stahl P91 kann etwa dadurch erreicht werden, dass die Beheizung induktiv erfolgt, wodurch sich unter Ausnützung des Skin-Effektes an der Innenoberfläche lokal eine etwas höhere Temperatur einstellt.

Es versteht sich, dass grundsätzlich beliebige andere Maßnahmen denkbar sind, um eine verstärkte Siliziumdiffusion während der Behandlung zu bewirken. Hierzu kann etwa unterstützend eine Strahlungsheizung, Laser impulse oder bereits erhitztes Prekursor-Gas, ein erhitzter Draht innerhalb eines Rohres oder dgl. mehr verwendet werden. Eine weitere Möglichkeit besteht darin, den CVD-Prozess durch eine Plasmaunterstützung zu intensivieren (Plasma-Enhanced-Coating). Es könnte beispielsweise ein Wasserstoffplasma oder ein Niederenergieplasma verwendet werden.

Obwohl das erfindungsgemäße Verfahren grundsätzlich den Vorteil von SiCl₄ ausnutzt, dass eine Siliziumfreisetzung erst bei derart hohen Temperaturen erfolgt, bei denen sich eine ausreichende Siliziumdiffusion einstellt, lässt sich das erfindungsgemäße Verfahren auch dann durchführen, wenn das Prozessgas gewisse Silan-Anteile enthält oder andere metallorganische Spender. Jedoch sollten derartige Anteile auf maximal etwa 10 % des Anteils von SiCl₄ begrenzt sein, da die Ausbildung von Oberflächenbeschichtungen nachteilig für den angestrebten Korrosionsschutz ist. Reine Beschichtungen, etwa aus reinem Silizium, können nämlich im Laufe der Zeit abplatzen und im Übrigen auch die Schweißbarkeit derartiger Stähle nachteilig beeinflussen.

### Beispiel 1

Stahlrohre aus dem Stahl P91 mit einem Außendurchmesser von 42 mm und 6 mm Wandstärke und einer Länge von 100 mm wurden untersucht. Die Rohre wurden durch ein Quarzrohr nach außen luftdicht abgeschlossen und in einer Heizvorrichtung zur induktiven Heizung eingesetzt. Die Testrohre waren somit von einer Spule zur induktiven Heizung umschlossen. Die Temperatur wurde sowohl mittels Pyrometer als auch mit Thermoelementen überwacht. Über eine geeignete Apparatur mit Massenflussreglern und thermostatischer Beheizung wurden die Prekursor-Gase und die anderen Gase zugeführt. Die Wiederholbarkeit wurde mittels eines Prozessleitsystems gewährleistet.

Hierbei erfolgte zunächst eine dreifache Evakuierung, bevor Wasserstoff im ständigen Massendurchfluss zugeführt wurde. Bei Wasserstoffdurchfluss erfolgte nun eine Aufheizung auf eine Durchschnittstemperatur von etwa 1050 °C. Dabei wurde lokal im Bereich der Innenoberfläche eine erhöhte Temperatur von etwa 1100 °C erreicht.

Der Prekursor aus SiCl₄ wurde mit einem Massenfluss von etwa 10 ml pro Minute zu einem Massenfluss an H₂ von 30 bis 60 ml pro Minute gemischt (bei 20 °C).

Diese Mischung wurde nun bei einem Gesamtdruck von einem bar mit einem Partialdruck von 0,3 bar zu der Wasserstoffatmosphäre in den Behandlungszyklen zudosiert. Es wurden 12 Behandlung s-zyklen von etwa 60 Sekunden Dauer, jeweils gefolgt von Diffusionszyklen von 90 Sekunden Dauer durchgeführt.

Nach dem letzten Diffussionszyklus wurde kurzzeitig NH₃ zugeführt, bevor eine Evakuierung erfolgte. Anschließend erfolgte eine Abkühlung auf Raumtemperatur durch Abschaltung der Heizung. Die Gesamtdauer des Glühprozesses bei etwa 1050 °C betrug hierbei etwa 45 Minuten. Anschließend wurde Stickstoff eingelassen und die Temperatur auf 750 °C erhöht und für etwa 60 Minuten eingehalten. Anschließend erfolgte Abkühlung auf Raumtemperatur durch Abschaltung.

Der Querschnitt einer so behandelten Probe wurde untersucht.

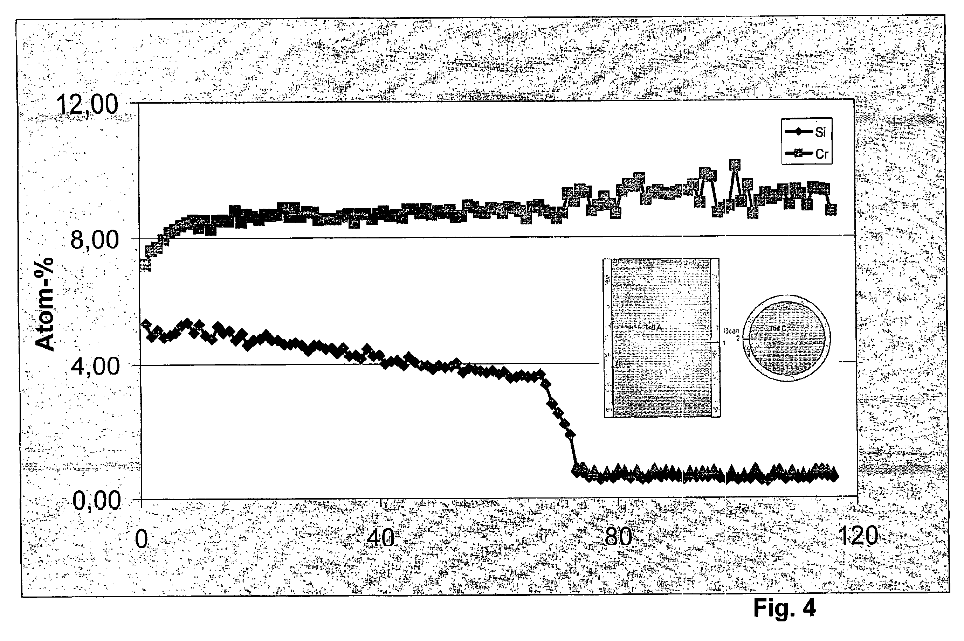

Fig. 4 zeigt das Ergebnis einer Mikrosondenanalyse, aus der die Siliziumkonzentration und die Chromkonzentration des Stahls in Abhängigkeit des Abstandes von der Innenoberfläche gezeigt ist.

Die Siliziumkonzentration liegt an der Oberfläche bei ca. 5 Atom-% und nimmt bis zu einer Entfernung von etwa 70 µm annähernd linear bis auf eine Konzentration ab, die geringfügig unter 4 Atom-% liegt. Anschließend erfolgt ein schneller Abfall auf eine Konzentration von nahe 0. Die Chromkonzentration ist lediglich unmittelbar an der Oberfläche unterhalb von 8 Atom-% bei etwa 7 Atom-% und nimmt schon in kurzer Entfernung von der Oberfläche, die im Bereich zwischen etwa 5 und 10 µm liegt, auf einen Wert in der Größenordnung von 9 Atom-% zu, der über den gesamten Querschnitt bis zu einem Abstand von etwa 120 µm von der Oberfläche annähernd beibehalten wird. Dies belegt, dass durch die Anwesenheit von Silizium die Diffusion von Chrom aus dem Innern des Stahls erleichtert wird, so dass ein an sich durch die Diffusion von Silizium zu vermutender Abfall der Chromkonzentration in diesem Bereich ausbleibt. Dies wirkt sich vorteilhaft auf die Korrosionsbeständigkeit der so erzeugten Diffusionsschicht aus.

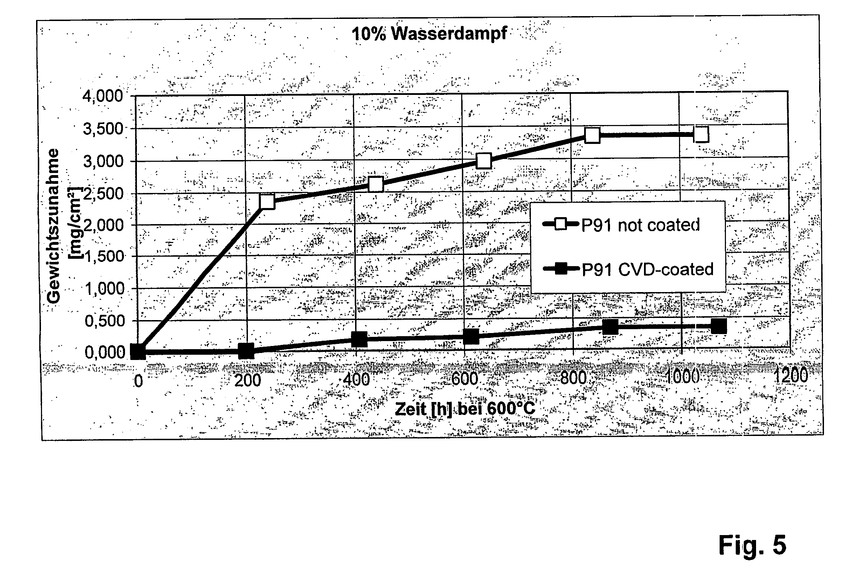

Fig. 5 zeigt das Ergebnis von Korrosionstests, die an unbehandeltem Stahl P91 durchgeführt wurden, im Vergleich zu Korrosionstests, die an nach dem zuvor beschriebenen Verfahren behandelten Proben aus P91 durchgeführt wurden. Auch die nichtbeschichteten Proben aus P91 wurden durch den vorgeschriebenen Wärmebehandlungszyklus gemäß Fig. 1 gehärtet und angelassen. In Fig. 5 ist nun die Gewichtszunahme nach Korrosionstests mit 10 % Wasserdampfatmosphäre in Abhängigkeit von der Zeit bei 600 °C dargestellt. Es ist klar erkennbar, dass die Gewichtszunahme der erfindungsgemäß behandelten Proben deutlich niedriger ist als die der unbehandelten Proben. Die Gewichtszunahme ist etwa eine Größenordnung niedriger.

In der sehr rauen Zunderschicht der Innenoberfläche wurde eine Einlagerung von Silizium bzw. SiO₂ festgestellt, wodurch die Zunderschicht praktisch versiegelt wurde. Darunter erstreckte sich die Silizium-Diffusionsschicht mit etwa 5 Atom-% Silizium.

### Beispiel 2

Unter sonst gleichen Bedingungen wie beim Beispiel 1 wurden insgesamt 30 Behandlungszyklen mit je 20 Sekunden Dauer mit SiCl4, jeweils gefolgt von Diffusionszyklen mit 40 Sekunden Dauer zur Chlorentfernung verwendet.

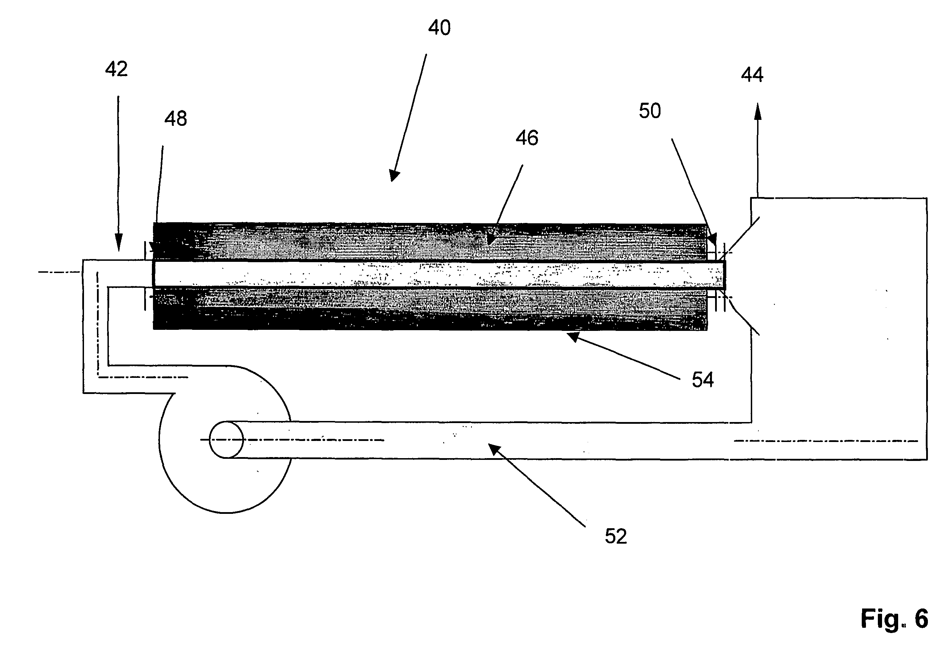

In Fig. 6 ist eine Vorrichtung 40 schematisch dargestellt, die zur Behandlung der Innenoberfläche von langen Rohren bei einem industriellen Prozess verwendet werden kann.

Die Vorrichtung 40 weist eine erste Aufnahme 48 und eine zweite Aufnahme 50 auf, mit der ein Rohr 46 dichtend an den Enden aufgenommen werden kann.

Zur Beheizung des Rohrs 46 dient eine nicht näher dargestellte Heizung 54, bei der es sich beispielsweise um eine Induktionsheizung handeln kann.

Am Eingang des Rohrs 46 können Gase zugeführt werden, wie etwa H₂, N₂, NH₃ und Prekursor-Gasmischungen aus SiCl₄ und H₂. Die Gase können mittels eines geeigneten Kreislaufes 52 kontinuierlich im Kreislauf durch das Rohr 46 geleitet werden. Abgase, wie etwa HCl, Cl₂ und dgl. können am Ausgang des Rohrs über eine geeignete Abgasbehandlung 44 nach außen abgeleitet werden.

Es versteht sich, das s anstelle einer induktiven Beheizung auch eine andersgeartete Beheizung, etwa eine konventionelle Beheizung in einem Langrohrofen, verwendet werden kann.

Vorzugsweise weist die Vorrichtung auch geeignete Hilfsmittel auf, um eine lokale Temperaturerhöhung im Bereich der zu behandelnden Innenoberfläche der Rohre 46 zu ermöglichen. Bei ausreichend kurzen Rohren kann dies beispielsweise durch eine Strahlungs-Zusatzheizung erfolgen. Alternativ hierzu könnten beispielsweise Laserimpulse verwendet werden.

Eine andere Möglichkeit besteht in der zusätzlichen Unterstützung des CVD-Prozesses durch ein Plasma.

Während im angegebenen Beispiel die CVD-Behandlung bei Atmosphärendruck ausgeführt wurde, ist auch eine Behandlung bei Niederdruck vorteilhaft durchführbar, z.B. zwischen etwa 0,1 und 1 bar Gesamtdruck. Bei Niederdruck steigt die Reaktionsfähigkeit, während die Diffusion kaum beeinflusst wird.

## Patentansprüche

1. Verfahren zum Korrosionsschutz von Bauteilen (46) aus warmfestem Stahl, insbesondere zum Korrosionsschutz von Kesselrohren aus einem chromhaltigen Stahl, bei dem die zu schützende Oberfläche durch ein Abscheidungsverfahren aus der Gasphase, insbesondere durch ein CVD-Verfahren, mit einem mindestens ein Behandlungsgas enthaltenden Gas vorzugsweise unter nicht oxidierender Atmosphäre vorzugsweise bei einer Temperatur zwischen 1000 °C und 1200 °C behandelt wird, wobei die Behandlung mit dem Behandlungsgas in mehreren aufeinander folgenden Behandlungszyklen (26) mit Diffusionszyklen (28) zwischen den Behandlungszyklen (26) durchgeführt wird, wobei das Behandlungsgas aus der Gruppe ausgewählt ist, die durch Chloride von Elementen der Gruppen IIb, IIIb, IVa und IVb gebildet ist, und wobei das Behandlungsgas vorzugsweise aus der durch SiCl₄, TiCl₄, AlCl₃ und ZnCl₂ gebildeten Gruppe ausgewählt ist.

2. Verfahren nach Anspruch 1, bei dem die Diffusionszyklen nach den Behandlungszyklen (26) mindestens so lang wie die Behandlungszyklen sind, vorzugsweise länger als die Behandlungszyklen sind.

3. Verfahren nach Anspruch 1, bei dem die Behandlungszyklen (26) 5 bis 120 Sekunden dauern, vorzugsweise 10 bis 30 Sekunden dauern.

4. Verfahren nach Anspruch 2 oder 3, bei dem die Diffusionszyklen (28) eine Länge haben, die dem 1,0-fachen bis dem 3,0-fachen, vorzugsweise dem 1,5-fachen bis dem 2,5-fachen der Länge der Behandlungszyklen (26) entsprechen.

5. Verfahren nach einem der vorhergehenden Ansprüche, bei dem 5 bis 60 Behandlungszyklen (26), vorzugsweise 10 bis 50, weiter bevorzugt 20 bis 40, besonders bevorzugt 25 bis 35 Behandlungszyklen (26) durchgeführt werden.

6. Verfahren nach einem der vorhergehenden Ansprüche, bei dem als Trägergas für das SiCl₄ enthaltende Gas ein reduzierendes Gas, vorzugsweise ein Wasserstoff enthaltendes Gas verwendet wird.

7. Verfahren nach einem der vorhergehenden Ansprüche, bei dem die Behandlung bei einer durchschnittlichen Temperatur zwischen 1040 °C und 1080 °C durchgeführt wird.

8. Verfahren nach einem der vorhergehenden Ansprüche, bei dem der Stahl im Bereich der zu behandelnden Oberfläche kurzzeitig auf eine erhöhte Temperatur oberhalb der durchschnittlichen Behandlungstemperatur erwärmt wird.

9. Verfahren nach Anspruch 8, bei dem zur kurzzeitigen lokalen Temperaturerhöhung im Bereich der zu behandelnden Oberfläche eine Induktionsheizung unter Ausnutzung des Skin-Effektes, eine Strahlungsheizung, eine Laserunterstützung, eine Mikrowellenheizung, erhitztes Gas oder ein erhitzter Draht oder dgl. verwendet wird.

10. Verfahren nach einem der vorhergehenden Ansprüche, bei dem die Behandlung mit Plasmaunterstützung erfolgt.

11. Verfahren nach einem der vorhergehenden Ansprüche, bei dem die Behandlung mit einem SiCl₄ enthaltenden Gas mit einer ersten Glühbehandlung (10) zum Härten des Stahls kombiniert wird.

12. Verfahren nach einem der vorhergehenden Ansprüche, bei dem die Behandlung von einer zweiten Glühbehandlung (14) bei einer niedrigeren Anlasstemperatur gefolgt wird.

13. Verfahren nach Anspruch 12, bei dem die zweite Glühbehandlung (14) mit einem Vergütungsschritt gekoppelt ist.

14. Verfahren nach Anspruch 12 oder 13, bei dem die zweite Glühbehandlung (14) bei einer Temperatur zwischen 650 °C und 850 °C, vorzugsweise zwischen 730 °C und 780 °C erfolgt.

15. Verfahren nach einem der Ansprüche 12 bis 14, bei dem die zweite Glühbehandlung (14) unter einer Atmosphäre, wie etwa Stickstoff, durchgeführt wird, die eine Freisetzung von Wasserstoff fördert.

16. Verfahren nach einem der vorhergehenden Ansprüche, bei dem vor der Behandlung ein Reinigungsschritt (22) vorzugsweise mit einem reduzierenden Gas, vorzugsweise mit Wasserstoff, durchgeführt wird.

17. Verfahren nach einem der vorhergehenden Ansprüche, bei dem nach Beendigung der Behandlungszyklen oder Diffusionszyklen (26, 28) ein stickstoffhaltiges Gas, insbesondere ein Ammoniak enthaltendes Gas, zugeführt wird (30).

18. Verfahren nach einem der vorhergehenden Ansprüche, bei dem nach Beendigung der Behandlungszyklen (26) oder der Diffusionszyklen (28) oder der Zufuhr von stickstoffhaltigem Gas (30), eine Evakuierung (32) durchgeführt wird.

19. Verfahren nach Anspruch 18, bei dem die Evakuierung (32) nach Beendigung des letzten Diffusionszyklus (28) oder nach der Zufuhr von stickstoffhaltigem Gas (30) noch bei erhöhter Temperatur durchgeführt wird.

20. Verfahren nach einem der vorhergehenden Ansprüche, bei dem die Innenoberfläche und/oder die Außenoberfläche der Bauteile (46) behandelt wird.

21. Verfahren nach einem der vorhergehenden Ansprüche, bei dem ein Stahl verwendet wird, der einen Chromanteil von weniger als 12 Gew.-% enthält, vorzugsweise einen Chromanteil zwischen 7 und 11 Gew.-% enthält.

22. Verfahren nach einem der vorhergehenden Ansprüche, bei dem ein Stahl verwendet wird, der 0,5 bis 3 Gew.-% Molybdän, vorzugsweise 0,8 bis 1,2 Gew.-% Molybdän enthält.

23. Verfahren nach einem der vorhergehenden Ansprüche, bei dem der Stahl 0,05 bis 0,8 Gew.-% Vanadium, vorzugsweise 0,1 bis 0,3 Gew.-% Vanadium enthält.

24. Verfahren nach einem der vorhergehenden Ansprüche, bei dem ein Stahl verwendet wird, der 0,01 bis 0,3 Gew.-% Niob, vorzugsweise 0,05 bis 0,15 Gew.-% Niob enthält.

25. Verfahren nach einem der vorhergehenden Ansprüche, bei dem ein Stahl verwendet wird, der 0,05 bis 0,2 Gew.-% Kohlenstoff, vorzugsweise 0,07 bis 0,15 Gew.-% Kohlenstoff enthält.

26. Verfahren nach einem der vorhergehenden Ansprüche, bei dem als Stahl der Stahl X10CrMoVNb9-1 (1.4903) verwendet wird.

27. Verfahren nach einem der vorhergehenden Ansprüche, bei dem das SiCl₄ enthaltende Gas vor einer Zuführung in eine Einrichtung zur Abscheidung aus der Gasphase auf eine Temperatur nahe der Raumtemperatur gehalten wird, vorzugsweise auf einer Temperatur zwischen 10 und 35 °C, besonders bevorzugt zwischen 15 und 30 °C gehalten wird.

28. Verfahren nach einem der vorhergehenden Ansprüche, bei dem die Behandlung bei Niederdruck unterhalb von 1 bar durchgeführt wird.

29. Verfahren nach einem der vorhergehenden Ansprüche, bei dem die Behandlung mit einer Aufkohlung kombiniert wird.

30. Verfahren nach einem der vorhergehenden Ansprüche, bei dem während der Behandlung Methan oder ein anderer Kohlenstoffspender zugeführt wird.

## Claims

1. A method for corrosion control on structural components (46) made from heat-resistant steel, in particular for corrosion control on boiler tubes made from chromic steel, wherein the surface to be protected is treated by a process of deposition from the gas phase, in particular by a CVD process, using gas containing at least one process gas, preferably in a non-oxidizing atmosphere and preferably at a temperature of between 1000° Celsius and 1200° Celsius, the treatment with the process gas being carried out in a plurality of successive treating cycles (26) with diffusion cycles (28) between the treating cycles (26), the process gas being selected from the group formed by chlorides of elements selected from the groups lib, Illb, IVa and IVb, and the process gas being preferably selected from the group formed by SiCl₄, TiCl₄, AlCI₃ and ZnCl₂.

2. The method as defined in Claim 1, wherein the diffusion cycles that follow the treating cycles (26) are at least as long as the treating cycles, preferably longer than the treating cycles.

3. The method as defined in Claim 1, wherein the treating cycles (26) have a duration of approximately 5 to 120 seconds, preferably approximately 10 to 30 seconds.

4. The method as defined in Claim 2 or Claim 3, wherein the diffusion cycles (28) have a duration equal to 1.0 times to 3.0 times, preferably 1.5 times to 2.5 times the length of the treating cycles.

5. The method as defined in any of the preceding claims, wherein 5 to 60 treating cycles (26), preferably 10 to 50, more preferably 25 to 35 treating cycles (26), are carried out.

6. The method as defined in any of the preceding claims, wherein a reducing gas, preferably a gas containing hydrogen is used as carrier gas for the gas containing the SiCl₄.

7. The method as defined in any of the preceding claims, wherein the treatment is carried out at an average temperature of between 1040° Celsius und 1080° Celsius.

8. The method as defined in any of the preceding claims, wherein the steel is heated up in the area of the surface to be treated for a short time to an increased temperature above the average treating temperature.

9. The method as defined in Claim 8, wherein an induction heating making use of the skin effect, a radiant heating, laser enhancement, a microwave heating, heated gas or a heated wire, or the like is used for locally increasing the temperature in the area of the surface to be treated.

10. The method as defined in any of the preceding claims, wherein plasma enhancement is used for the treatment.

11. The method as defined in any of the preceding claims, wherein the treatment with a gas containing SiCl₄ is combined with a first annealing treatment (10) for hardening the steel.

12. The method as defined in any of the preceding claims, wherein the treatment is followed by a second annealing treatment (14) at a lower tempering temperature.

13. The method as defined in Claim 12, wherein the second annealing treatment (14) is coupled with a hardening and tempering step.

14. The method as defined in Claim 12 or Claim 13, wherein the second annealing treatment (14) is carried out at a temperature of between 650° Celsius and 850° Celsius, preferably between 730° Celsius and 780° Celsius.

15. The method as defined in any of claims 12 to 14, wherein the second annealing treatment (14) is carried out under an atmosphere, such as nitrogen, that facilitates the release of hydrogen.

16. The method as defined in any of the preceding claims, wherein a cleaning step (22) is carried out before the treatment preferably using a reducing gas, preferably hydrogen.

17. The method as defined in any of the preceding claims, wherein a gas containing nitrogen, in particular a gas containing ammonia, is introduced after termination of the treating cycles or diffusion cycles (26, 28).

18. The method as defined in any of the preceding claims, wherein an evacuation step (32) is carried out after the end of the treating cycles (26) or the diffusion cycles (28) or the introduction of gas (30) containing nitrogen.

19. The method as defined in Claim 18, wherein the evacuation step (32) is carried out after the end of the last diffusion cycle (28) or after the introduction of gas (30) containing nitrogen, while the temperature is still increased.

20. The method as defined in any of the preceding claims, wherein the inner surface and/or the outer surface of the structural components (46) are treated.

21. The method as defined in any of the preceding claims, wherein the steel used has a chromium content of less than 12 % by weight, preferably a chromium content of between 7 and 11 % by weight.

22. The method as defined in any of the preceding claims, wherein the steel used contains 0.5 to 3 % by weight of molybdenum, preferably 0.8 to 1.2 % by weight of molybdenum.

23. The method as defined in any of the preceding claims, wherein the steel used contains 0.05 to 0.8 % by weight of vanadium, preferably 0.1 to 0.3 % by weight of vanadium.

24. The method as defined in any of the preceding claims, wherein the steel used contains 0.01 to 0.3 % by weight of niobium, preferably 0.05 to 0.15 % by weight of niobium.

25. The method as defined in any of the preceding claims, wherein the steel used contains 0.05 to 0.2 % by weight of carbon, preferably 0.07 to 0.15 % by weight of carbon.

26. The method as defined in any of the preceding claims, wherein the steel used is steel grade X10CrMoVNb9-1 (1.4903).

27. The method as defined in any of the preceding claims, wherein prior to being introduced into a device for deposition from the gas phase the gas containing the SiCl₄ is kept at a temperature near room temperature, preferably at a temperature of between 10 and 35° Celsius, more preferably between 15 and 30° Celsius.

28. The method as defined in any of the preceding claims, wherein the treatment is carried out at low pressure below 1 bar.

29. The method as defined in any of the preceding claims, wherein the treatment is combined with a carburization step.

30. The method as defined in any of the preceding claims, wherein methane or another carbon donor is introduced during the treatment.

## Revendications

1. Procédé pour protéger des composants (46) en acier thermorésistant contre la corrosion, notamment pour protéger des tubes de chaudière en acier à teneur en chrome contre la corrosion, dans lequel la surface à protéger est traitée par un procédé dépôt à partir d'une phase gazeuse, notamment par dépôt chimique en phase vapeur (CVD), avec un gaz contenant au moins un gaz de traitement, de préférence dans une atmosphère non oxydante, de préférence à une température comprise entre 1000 °C et 1200 °C, le traitement avec le gaz de traitement étant réalisé en plusieurs cycles de traitement (26) successifs avec des cycles de diffusion (28) entre les cycles de traitement (26), le gaz de traitement étant choisi dans le groupe formé par les chlorures d'éléments des groupes IIb, IIIb, IVa et IVb et le gaz de traitement étant de préférence choisi dans le groupe formé par SiCl₄, TiCl₄, AlCl₃ et ZnCl₂.

2. Procédé selon la revendication 1, dans lequel les cycles de diffusion qui suivent les cycles de traitement (26) sont au moins aussi longs que les cycles de traitement, de préférence plus longs que les cycles de traitement.

3. Procédé selon la revendication 1, dans lequel les cycles de traitement (2) durent de 5 à 120 secondes, de préférence de 10 à 30 secondes.

4. Procédé selon la revendication 2 ou 3, dans lequel les cycles de diffusion (28) ont une durée correspondant à 1,0 à 3,0 fois, de préférence à 1,5 à 2,5 fois, la durée des cycles de traitement (26).

5. Procédé selon l'une quelconque des revendications précédentes, dans lequel on réalise de 5 à 60 cycles de traitement (26), de préférence de 10 à 50, de manière davantage préférée de 20 à 40 et de manière préférée entre toutes de 25 à 35 cycles de traitement.

6. Procédé selon l'une quelconque des revendications précédentes pour lequel on utilise un gaz réducteur, de préférence un gaz contenant de l'hydrogène, en tant que gaz vecteur pour le gaz contenant du SiCl₄.

7. Procédé selon l'une quelconque des revendications précédentes, dans lequel le traitement est réalisé à une température moyenne comprise entre 1040 °C et 1080 °C.

8. Procédé selon l'une quelconque des revendications précédentes, dans lequel l'acier, dans la zone de la surface à traiter, est chauffé brièvement à une température supérieure à la température de traitement moyenne.

9. Procédé selon la revendication 8, dans lequel on utilise un chauffage par induction en exploitant l'effet pelliculaire, un chauffage à rayonnement, une assistance au laser, un chauffage par micro-ondes, un gaz brûlé ou un fil métallique chauffé ou similaire pour augmenter brièvement et localement la température dans la zone de la surface à traiter.

10. Procédé selon l'une quelconque des revendications précédentes, dans lequel le traitement est réalisé avec une assistance au plasma.

11. Procédé selon l'une quelconque des revendications précédentes, dans lequel le traitement avec un gaz contenant du SiCl₄ est combiné avec un premier recuit (10) pour durcir l'acier.

12. Procédé selon l'une quelconque des revendications précédentes, dans lequel le traitement est suivi d'un deuxième recuit (14) à une température d'admission plus faible.

13. Procédé selon la revendication 12, dans lequel le deuxième recuit (14) est couplé à une étape de traitement antiréfléchissant.

14. Procédé selon la revendication 12 ou 13, dans lequel le deuxième recuit (14) est réalisé à une température comprise entre 650 °C et 850 °C, de préférence entre 730 °C et 780 °C.

15. Procédé selon l'une quelconque des revendications 12 à 14, dans lequel le deuxième recuit (14) est réalisé sous une atmosphère, tel que l'azote, qui favorise la libération de l'hydrogène.

16. Procédé selon l'une quelconque des revendications précédentes dans lequel une étape de nettoyage (22) est réalisée de préférence avec un gaz réducteur, de préférence de l'hydrogène, avant le traitement.

17. Procédé selon l'une quelconque des revendications précédentes, dans lequel on fait arriver (30) un gaz contenant de l'azote, notamment un gaz contenant de l'ammoniaque, après la fin des cycles de traitement ou des cycles de diffusion (26, 28).

18. Procédé selon l'une quelconque des revendications précédentes, dans lequel une évacuation (32) est réalisée à la fin des cycles de traitement (26) ou des cycles de diffusion (28) ou de l'arrivée de gaz contenant de l'azote (30).

19. Procédé selon la revendication 18, dans lequel l'évacuation (32) est réalisée encore à température élevée, après la fin du dernier cycle de diffusion (28) ou après l'arrêt de l'arrivé d'un gaz contenant de l'azote (30).

20. Procédé selon l'une quelconque des revendications précédentes, dans lequel on traite la surface intérieure et/ou la surface extérieure des composants (46).

21. Procédé selon l'une quelconque des revendications précédentes, dans lequel on utilise un acier ayant une teneur en chrome inférieure à 12 % en poids, de préférence une teneur en chrome comprise entre 7 et 11 % en poids.

22. Procédé selon l'une quelconque des revendications précédentes, dans lequel on utilise un acier contenant de 0,5 à 3 % en poids de molybdène, de préférence de 0,8 à 1,2 % en poids de molybdène.

23. Procédé selon l'une quelconque des revendications précédentes, dans lequel l'acier comprend de 0,05 à 0,8 % en poids de vanadium, de préférence de 0,1 à 0,3 % en poids de vanadium.

24. Procédé selon l'une quelconque des revendications précédentes, dans lequel on emploie un acier contenant de 0,01 à 0,3 % en poids de niobium, de préférence de 0,05 à 0,15 % en poids de niobium.

25. Procédé selon l'une quelconque des revendications précédentes, dans lequel on utilise un acier contenant de 0,05 à 0,2 % en poids de carbone, de préférence de 0,07 à 0,15 % en poids de carbone.

26. Procédé selon l'une quelconque des revendications précédentes, dans lequel l'acier utilisé est l'acier X10CrMoVNb9-1 (1.4903).

27. Procédé selon l'une quelconque des revendications précédentes, dans lequel le gaz contenant du SiCl₄ est maintenu à une température proche de la température ambiante, de préférence à une température comprise entre 10 et 35 °C, de manière davantage préférée entre 15 et 30 °C, avant d'être envoyé dans un dispositif de dépôt à partir d'une phase gazeuse.

28. Procédé selon l'une quelconque des revendications précédentes dans lequel le traitement à basse pression est réalisé à moins de 1 bar.

29. Procédé selon l'une quelconque des revendications précédentes, dans lequel le traitement est combiné avec une cémentation.

30. Procédé selon l'une quelconque des revendications précédentes, dans lequel on fait arriver, pendant le traitement, du méthane ou une autre source de carbone.
